# EUROPEAN PATENT APPLICATION

(11) **EP 1 202 453 A2**
(43) Date of publication of application: **02.05.2002**
(21) Application number: 01308147.6
(22) Date of filing: 25.09.2001
(51) Int. Cl.: H03H 9/215

(54) **Flexural mode quartz crystal resonator**

(30) Priority: 31.10.2000 JP 2000332160; 06.02.2001 JP 2001029884
(71) Applicant: Piedek Technical Laboratory, Tokyo (JP)
(72) Inventor: Kawashima, Hirofumi, c/o Piedek Technical Lab., Tokyo (JP)
(74) Representative: Style, Kelda Camilla Karen

(57) **Abstract**

The flexural mode, tuning fork, quartz crystal resonator comprising of tuning fork tines and tuning fork base is shown with novel shape and electrode construction, which provides a high electro-mechanical transformation efficiency, even when said resonator is miniaturized. As a result of which the miniaturized quartz crystal resonator may be provided with a small series resistance R₁ and a high quality factor Q. This is accomplished by grooves or a step difference and by electrode construction on the tuning fork tines and/or tuning fork base of the tuning fork, quartz crystal resonator. In addition, an improvement of the frequency temperature behaviour for the flexural mode, tuning fork, quartz crystal resonator is accomplished by connecting a plurality of resonators integrally at their respective tuning fork bases. Quartz crystal resonators with differing peak temperature points are electrically connected in parallel. Consequently, the integrally formed quartz crystal resonator has an excellent frequency temperature behaviour over a wide temperature range of between -10°C to +50°C.

## Description

The present invention relates to a flexural mode, tuning fork, quartz crystal resonator.

### BACKGROUND OF THE INVENTION

Tuning fork, quartz crystal resonators which vibrate in flexural mode are widely used as a time standard in consumer products, wearable equipment and communication equipment (such as wristwatches, cellular phones, and pagers). Recently, because of miniaturization and the light weight nature of these products, a smaller flexural mode, tuning fork, quartz crystal resonator is required with a small series resistance and a high quality factor.

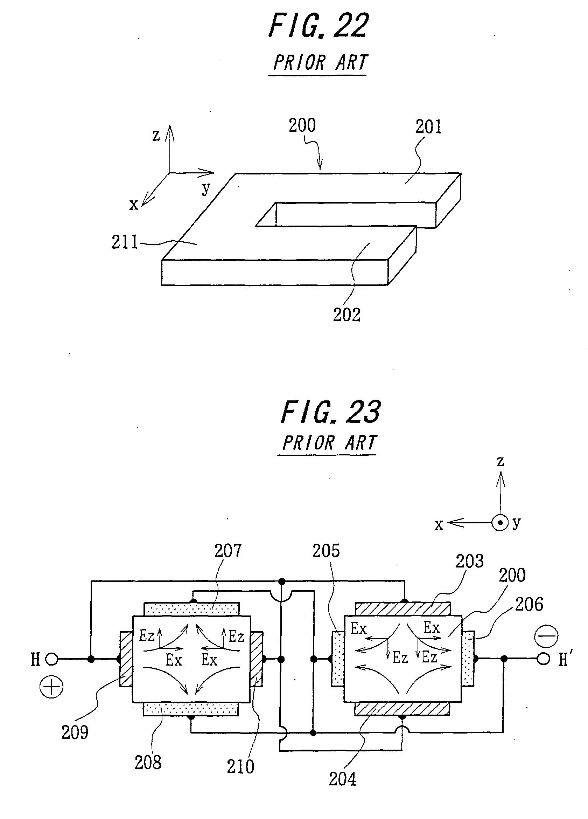

It is, however, impossible to obtain a conventional miniaturized, flexural mode, tuning fork, quartz crystal resonator with a small series resistance and a high quality factor. When miniaturized the conventional flexural mode, tuning fork, quartz crystal, resonator shown in FIG.22 (which has electrodes on the obverse faces 203, 207, reverse faces 204, 208 and the four sides 205, 206, 209, 210 of each tuning fork tine, as also shown in FIG. 23 - a cross-sectional view of tuning fork tines of FIG. 22), has a smaller electro-mechanical transformation efficiency, which provides a small electric field (i.e. Ex becomes small), a large series resistance, and a reduced quality factor. In FIG. 22, the conventional tuning fork resonator 200 is shown with tuning fork tines 201, 202 and tuning fork base 211.

In addition, it is impossible to obtain a flexural mode, tuning fork, quartz crystal resonator with a small frequency change over a wide temperature range of between -10°C to +50°C because the resonator has a temperature coefficient with a parabolic curve, and whose second order temperature coefficient is approximately -3.5×10⁻⁸/°C². This value is comparatively large as compared with AT cut quartz crystal resonators vibrating in thickness shear mode.

It is, therefore, an aim of embodiments of the invention to provide a resonator which overcomes or at least mitigates one or more of the above problems.

### SUMMARY OF THE INVENTION

Embodiments of the present invention relate to the shape and electrode construction of a flexural mode, tuning fork, quartz crystal resonator, and in particular, a novel shape and electrode construction for a flexural mode, tuning fork, quartz crystal resonator available for consumer products and communication equipment requiring miniaturized, high accuracy, shock proof and low priced quartz crystal resonators.

It is an aim of the embodiments of the present invention to provide a miniaturized flexural mode, tuning fork, quartz crystal resonator with a small series resistance R₁ and a high quality factor Q.

It is an another aim of the embodiments of the present invention to provide a flexural mode, tuning fork, quartz crystal resonator with an excellent frequency temperature behaviour over a wide temperature range (of -10°C to +50°C).

According to one aspect of the present invention, there is provided a tuning fork, quartz crystal resonator vibrating in flexural mode comprising; tuning fork tines, and a tuning fork base, at least one groove provided in the central line portion of each of said tuning fork tines, at least one first electrode provided inside each groove, at least one second electrode provided on the sides of said tuning fork tines, and for each tine said at least one second electrode having an opposite polarity to said at least one first electrode.

According to a second aspect of the present invention there is provided a quartz crystal, tuning fork, resonator vibrating in flexural mode comprising; tuning fork tines, tuning fork base, a plurality of grooves provided on the tuning fork base where said base is coupled to the tuning fork tines, and electrodes provided in said grooves.

According to a third aspect of the invention there is provided a tuning fork, quartz crystal resonator vibrating in flexural mode comprising; tuning fork tines, a tuning fork base, said tuning fork tines having step difference portions, with at least one first electrode on the said step difference portions, with at least one second electrode disposed on the side of said tuning fork tines, and said at least one first and at least one second electrodes being of opposite polarity.

According to a fourth aspect of the invention there is provided a resonator comprising; a plurality of flexural mode, tuning fork, quartz crystal resonators being connected and formed integrally at each tuning fork base wherein said quartz crystal resonators are coupled to each other at the respective tuning fork bases and having an angle of separation of 0° to 30°.

Embodiments of the present invention may provide a high electro-mechanical transformation efficiency.

Embodiments of the present invention use grooves or step differences and an electrode construction arranged on the tuning fork tines and/or tuning fork base of a flexural mode, tuning fork, quartz crystal resonator.

Preferably, the resonator has grooves including the central line of the central portions for each tuning fork tine and the electrodes disposed inside the grooves and disposed on the sides of each tuning fork tine. Alternatively or additionally the grooves may be arranged on the tuning fork base and the electrodes disposed inside the grooves.

Preferably the resonator has a step difference constructed at tuning fork tines and/or tuning fork base and electrodes disposed on the step difference portions.

Preferably, at least two tuning fork resonators are connected and formed integrally at their respective tuning fork base may improve the frequency temperature behaviour. The quartz crystal resonators whose peak temperature points are different, may be connected electrically in parallel. As a result, the integrally formed quartz crystal resonator may have excellent frequency temperature behaviour over a wide temperature range of -10°C to +50°C.

For a better understanding of the present invention, and as to how the same may be carried into effect, reference will now be made by way of example to the accompanying drawings in which:
FIG. 1 is a general view of a flexural mode quartz crystal resonator of tuning fork type with grooves at each tuning fork tine, embodying the present invention;
FIG. 2 is a A-A' and B-B' cross-sectional views of the tuning fork tines of FIG. 1 illustrating electrode construction;
FIG. 3 is a plan view of the tuning fork, quartz crystal resonator of FIG. 1;
FIG. 4 is the bottom view of FIG. 3;
FIG. 5 is a general view of a flexural mode, tuning fork, quartz crystal resonator, embodying the present invention, and having plural grooves at the tuning fork base;
FIG. 6 is a D-D' cross-sectional view of the tuning fork base of FIG. 5 and illustrating electrode construction;
FIG. 7 is a plan view of the flexural mode quartz crystal resonator of FIG. 5;
FIG. 8 is a plan view of two flexural mode, tuning fork, quartz crystal resonators connected at their tuning fork bases with an angle φ, embodying the present invention;
FIG. 9 shows a diagram of an electrical connection for the flexural mode quartz crystal resonator of FIG. 8;
FIG. 10 shows an example of frequency temperature behaviour of embodiments of the present invention;
FIG. 11 is a plan view of an arrangement embodying the present invention which has two flexural mode, tuning fork, quartz crystal resonators connected at each tuning fork base with different-tuning fork tine dimensional ratios;
FIG. 12 is a plan view of a flexural mode, tuning fork, quartz crystal resonator embodying the present invention;
FIG. 13 is a plan view of a flexural mode, tuning fork, quartz crystal resonator embodying the present invention;
FIG. 14 is a F-F' cross-sectional view of the tuning fork base of FIG. 13 and illustrating electrode construction;
FIG. 15 is a general view of a flexural mode, tuning fork, quartz crystal resonator embodying the present invention and its coordinate system;
FIG. 16 is a plan view of the flexural mode quartz crystal resonator of FIG. 15;
FIG. 17 is a I-I' cross-sectional view of the tuning fork tines of FIG. 16 and illustrating electrode construction;
FIG. 18 is a general view of a flexural mode, tuning fork, quartz crystal resonator embodying the present invention and its coordinate system;
FIG. 19 is a plan view of the flexural mode quartz crystal resonator of FIG. 18;
FIG. 20 is a J-J' cross-sectional view of the tuning fork tines of FIG. 19 and illustrating electrode construction;
FIG. 21 is a plan view of an arrangement of three flexural mode, tuning fork, quartz crystal resonators embodying the present invention;
FIG. 22 is a general view of the conventional flexural mode, tuning fork, quartz crystal resonator;
FIG. 23 is a cross-sectional view of the tuning fork tines of FIG. 22 and illustrating electrode construction;

### DETAILED DESCRIPTION

Referring now to the drawings, the embodiments of the present invention will be described in full detail.

### Embodiment 1

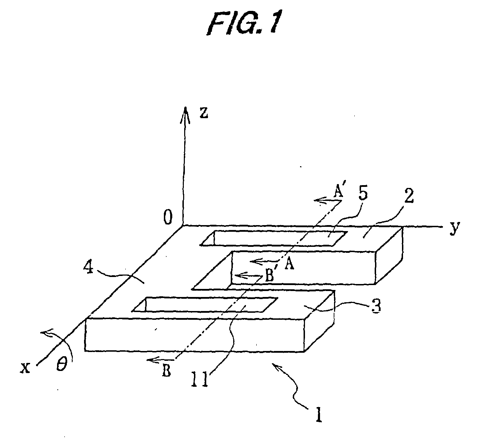

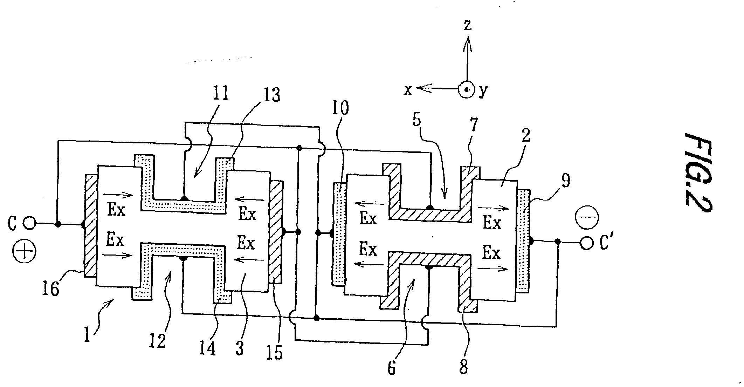

FIG. 1 shows a general view of a flexural mode, tuning fork, quartz crystal resonator embodying the present invention and its coordinate system. The coordinate system consists of an origin O, an electrical axis x, a mechanical axis y and an optical axis z of quartz, namely, O-xyz. A flexural mode, tuning fork, quartz crystal resonator 1 embodying the present invention comprises a first tuning fork tine 2, a second tuning fork tine 3 and a tuning fork base 4, the first tuning fork tine 2 and the second tuning fork tine 3 are connected at the tuning fork base 4. In addition, grooves 5 and 11 are constructed within the obverse face of tuning fork tines 2 and 3 which include a portion of the central line, respectively, as shown in FIG. 2, the same grooves are constructed within the reverse face of the tines 2 and 3. A cut angle θ, which has a typical value of 0° to 10°, is rotated from a Z-plate about the x axis.

FIG. 2 shows the A-A' and B-B' cross-sectional views of the tuning fork tines of FIG. 1 and electrode construction within the grooves. The A-A' cross-sectional view of the tuning fork tine 2 is shown on the right side and the B-B' cross-sectional view of the tuning fork tine 3 on the left side. The tuning fork tine 2 has grooves 5 and 6 cut into it, which include a portion of central line of the tine 2. The grooves 5 and 6 have a first set of electrodes 7 and 8 of the same polarity, while the sides of the tine 2 have a second set of electrodes 9 and 10 having an opposite polarity to the first set of electrodes 7 and 8. The tuning fork tine 3 has grooves 11 and 12 constructed in a similar manner as tuning fork tine 2. The grooves 11 and 12 have a third set of electrodes 13 and 14 of the same polarity, and the sides of the tine 3 have a fourth set of electrodes 15 and 16 with the opposite polarity to the third electrodes 13 and 14. The electrodes disposed on the tuning fork tines 2 and 3 are connected as shown in FIG. 2, namely, two electrode terminals of different polarity C-C' are obtained.

In detail, the first set of electrodes 7 and 8 disposed on the grooves 5 and 6 of the tuning fork tine 2 have the same polarity as the fourth set of electrodes 15 and 16 disposed on both sides of the tuning fork tine 3, while the second set of electrodes 9 and 10 disposed on both sides of the tuning fork tine 2 have the same polarity as the third set of electrodes 13 and 14 disposed on the grooves 11 and 12 of the tine 3. Now, when a direct voltage is applied between the electrode terminals C-C', an electric field Ex occurs along the arrow direction inside the tuning fork tines 2 and 3. As the electric field Ex occurs perpendicular to the electrodes disposed on the tuning fork tines, as shown in the arrow signs, the electric field Ex has a very large value and a large distortion occurs at the tuning fork tines. As a result, a flexural mode, tuning fork, quartz crystal resonator is obtained with a small series resistance R₁ and a high quality factor Q because even when miniaturized there is a large electro-mechanical transformation efficiency for the resonator.

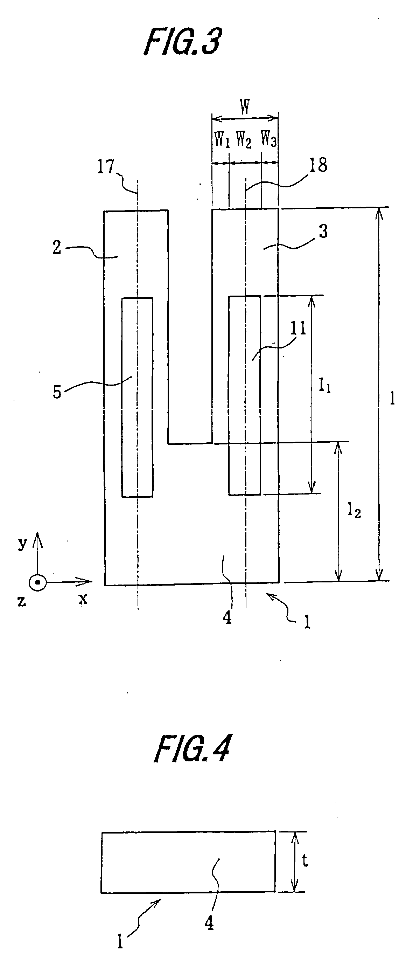

FIG. 3 shows a plan view of a tuning fork, quartz crystal resonator 1 of FIG. 1. In FIG. 3, the construction and the dimension of grooves 5 and 11 are described in detail. The groove 5 is constructed to include a portion of the central line 17 of the tuning fork tine 2, the groove 11 is similarly constructed to include a portion of the central line 18 of the tuning fork tine 3. The width W₂ of the grooves 5 and 11 which includes a portion of the central lines 17 and 18 respectively, is preferable because the tuning fork tines 2 and 3 can vibrate in flexural mode very easily. In other words, a flexural mode, tuning fork, quartz crystal resonator can be obtained with a small series resistance R₁ and a high quality factor Q. The total width W of the tuning fork tines 2 and 3 has a relationship of W=W₁+W₂+W₃, and in general the grooves are constructed so that W₁=W₃. In addition, the width W₂ of the grooves is constructed so that W₂ ≥ W₁, W₃. The length l₁ of the grooves 5 and 11 of tuning fork tines 2 and 3 extends into the tuning fork base 4 (which has a dimension of the length l₂) Furthermore, the total length l is determined by the frequency requirement and the size of the housing case. In this embodiment the grooves 5 and 11 of tuning fork tines 2 and 3 extend into the tuning fork base 4 in series, but embodiment of the present invention includes a plurality of grooves divided in the length direction of the tuning fork tines.

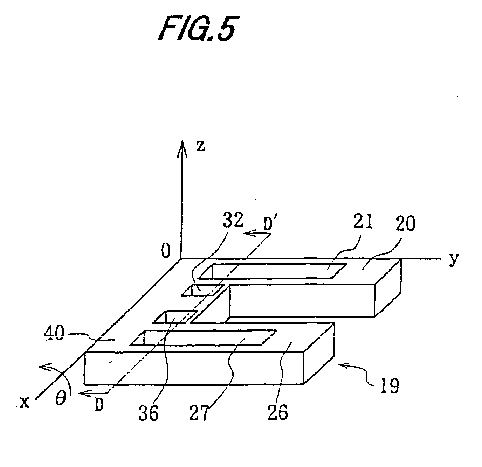

FIG. 4 shows a bottom view of a tuning fork quartz crystal resonator 1 of FIG. 3, which has a dimension of thickness t. In summary the embodiments shown within FIG. 1 to FIG. 3, the tuning fork tines have four grooves within the obverse and the reverse faces thereof and electrodes provided inside the grooves as well as electrodes disposed on both sides of the tuning fork tines. The embodiments of the present invention, however, may have at least one groove within at least at one surface of the tuning fork tines and an electrode inside the at least one groove as well as electrodes disposed on both sides of the tuning fork tine. Also, it is provided that the first electrode inside the groove and the second electrodes on said side of the tine next to said electrode are of opposite polarity.

### Embodiment 2

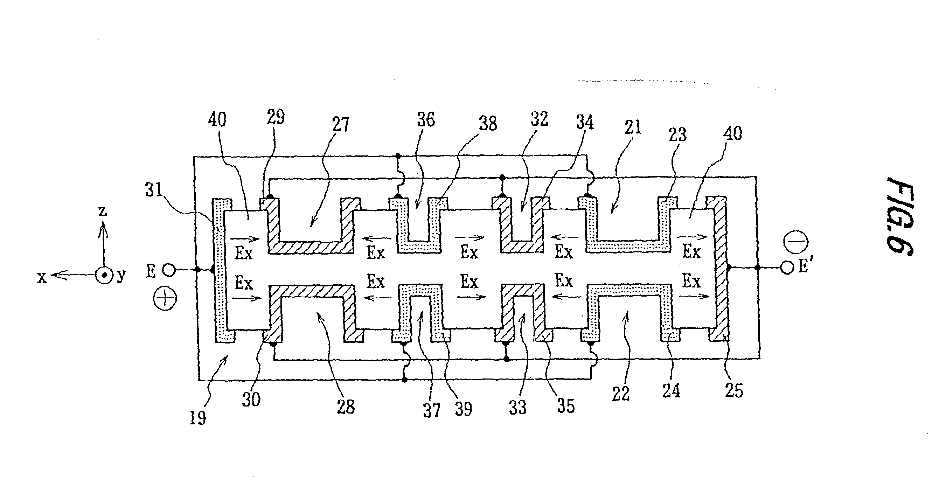

FIG. 5 shows another embodiment of a tuning fork, quartz crystal resonator of the present invention, namely, a general view of a flexural mode, tuning fork, quartz crystal resonator19 and its coordinate system O-xyz. A cut angle θ, which has a typical value of 0° to 10°, is rotated from a Z-plate about the x axis. The flexural mode, tuning fork, quartz crystal resonator 19 comprises two tuning fork tines 20 and 26 and tuning fork base 40. The tuning fork tines 20 and 26 have grooves 21 and 27 respectively, with the grooves 21 and 27 extending into the tuning fork base 40. In addition, the tuning fork base 40 has the additional grooves 32 and 36.

FIG. 6 shows a D-D' cross-sectional view of the tuning fork base 40 for the flexural mode, tuning fork, quartz crystal resonator 19 of FIG. 5. In FIG. 6, the shape of the electrode construction within the tuning fork base 40 for the quartz crystal resonator of FIG. 5 is described in detail. The section of the tuning fork base 40 which couples to the tuning fork tine 20 has the grooves 21 and 22 cut into the obverse and the reverse faces of the base 40. Also, the section of the tuning fork base 40 which couples to the tuning fork tine 26 has the grooves 27 and 28 cut into the obverse and the reverse faces of the base 40. In addition to these grooves, the tuning fork base 40 has the grooves 32 and 36 cut between the grooves 21 and 27, and also, the base 40 has the grooves 33 and 37 cut between the grooves 22 and 28.

Furthermore, the grooves 21 and 22 have the first electrodes 23 and 24 both of the same polarity, the grooves 32 and 33 have the second electrodes 34 and 35 both of the same polarity, the grooves 36 and 37 have the third electrodes 38 and 39 both of the same polarity, the grooves 27 and 28 have the fourth electrodes 29 and 30 both of same polarity and the sides of the base 40 have the fifth and sixth electrodes 25 and 31, each of opposite polarity. In more detail, the fifth, fourth, and second electrodes 25, 29, 30, 34 and 35 have the same polarity, while the first, sixth and third electrodes 23, 24, 31, 38 and 39 have the opposite polarity to the others. Two electrode terminals E-E' are constructed. That is, the electrodes disposed inside the grooves constructed opposite each other in the thickness (z axis) direction have the same polarity. Also, the electrodes disposed opposite each other across adjoining grooves have opposite polarity.

Now, when a direct voltage is applied between the electrode terminals E-E' (E terminal: plus, E' terminal: minus), an electric field Ex occurs in the arrow direction as shown in FIG. 6. As the electric field Ex occurs perpendicular to the electrodes disposed on the tuning fork base, the electric field Ex has a very large value and a large distortion occurs at the tuning fork base, so that a flexural mode, tuning fork, quartz crystal resonator is obtained with a small series resistance R₁ and a high quality factor Q, even if it is miniaturized.

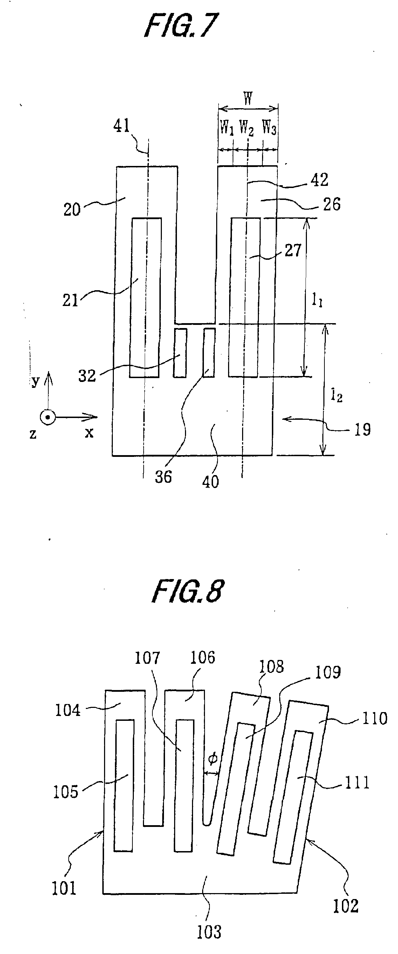

FIG. 7 shows a plan view of a tuning fork, quartz crystal resonator 19 of FIG. 5. In FIG. 7, the disposition of the grooves 21 and 27 is particularly described in detail. The tuning fork tine 20 has the groove 21 cut including a portion of the central line 41 of the tine, as well, the tuning fork tine 26 has also the groove 27 cut including a portion of the central line 42 of the tine. In addition, a flexural mode, tuning fork, quartz crystal resonator embodying the present invention has grooves 32 and 36 between the grooves 21 and 27 constructed at the tuning fork base 40 and the tuning fork tines 20 and 26.

Thus, a flexural mode, tuning fork, quartz crystal resonator with the shape and the electrode construction embodying the present invention has excellent electrical characteristics, even if it is miniaturized. Namely, the quartz crystal resonator has a small series resistance R₁ and a high quality factor Q. The width dimension W=W₁+W₂+W₃, and length dimensions l₁ and l₂, are as already described in relation to FIG. 3.

### Embodiment 3

FIG. 8 shows a plan view of an arrangement of flexural mode, tuning fork, quartz crystal resonators showing a further embodiment of the present invention. Two flexural mode quartz crystal resonators of tuning fork type 101, 102 are connected and formed integrally with an angle φ of 0° to 30° between each tuning fork base 103. In addition, the tuning fork tines 104 and 106 for the flexural mode, tuning fork, quartz crystal resonator 101 have grooves 105 and 107 and the tuning fork tines 108 and 110 for the flexural mode, tuning fork, quartz crystal resonator 102 have grooves 109 and 111.

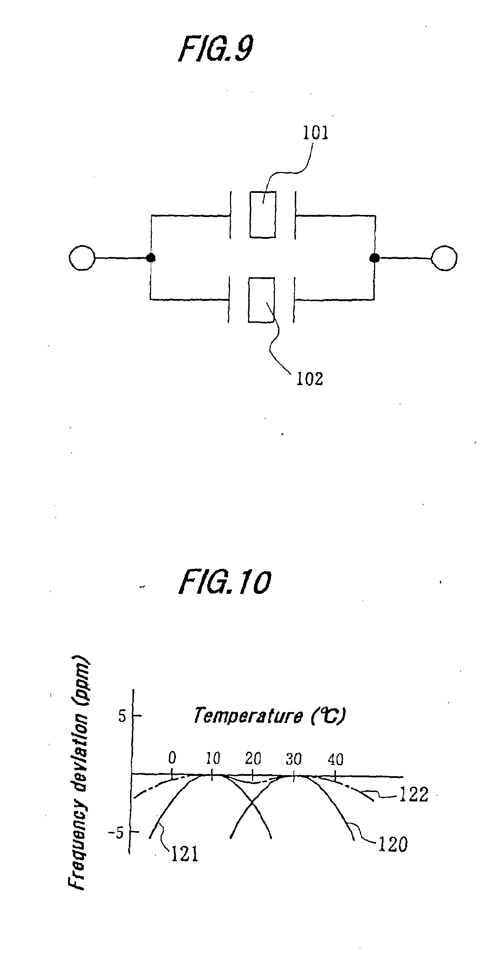

Accordingly, as each flexural mode quartz crystal resonator of tuning fork type has a different frequency temperature behaviour dependent on the angle φ, an improvement of the frequency temperature behaviour for the tuning fork, quartz crystal resonator can be performed by electrically connecting the two quartz crystal resonators of tuning fork type in parallel. An aim of embodiments of the present invention maybe achieved even if the same-designed resonators have the angle φ=0° because flexural mode quartz crystal resonators of tuning fork type, which are manufactured in mass production, have a distribution of frequency temperature behaviours due to manufacturing tolerances. In other words there will be small differences between the two resonators. An electrical connection diagram for both flexural mode, tuning fork, quartz crystal resonators 101, 102 is shown in FIG. 9. The resonators are connected in parallel electrically.

### Embodiment 4

FIG. 10 shows an example of frequency temperature behaviour for an integrally formed flexural mode, tuning fork, quartz crystal resonator embodying the present invention. The quartz crystal resonator 101 shown in FIG. 8 has frequency temperature behaviour 120 whose peak temperature point is approximately 30°C, while the resonator 102 shown in FIG. 8 has frequency temperature behaviour 121 whose peak temperature point is approximately 10°C. The compensated frequency temperature behaviour for both quartz crystal resonators connected in parallel electrically is shown by the curve 122. Thus, the integrally formed flexural mode, tuning fork, quartz crystal resonator embodying the present invention may be miniaturized and obtained with excellent frequency temperature behaviour.

### Embodiment 5

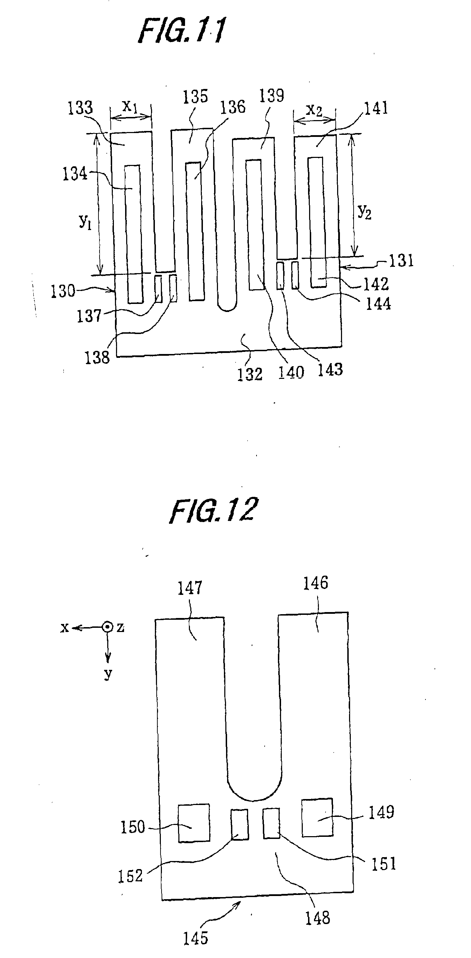

FIG. 11 shows a further embodiment of the present invention, and a plan view of flexural mode, tuning fork, quartz crystal resonators embodying the present invention. In FIG. 8, an angle φ is constructed between both quartz crystal resonators to change the peak temperature point of the resonators, but, in this embodiment, it is possible to change the peak temperature point of flexural mode, tuning fork, quartz crystal resonators by changing a dimension of width x₁, length y₁ and width x₂, length y₂ of the tuning fork tines. Namely, a peak temperature point of frequency temperature behaviour for a flexural mode, tuning fork, quartz crystal resonator depends upon the width-to-length ratio (x₁/y₁) or the width-to-length ratio (x₂/y₂).

Therefore, resonators with different peak temperature points are obtained by changing the width- to- length ratio of a flexural mode, tuning fork, quartz crystal resonator. As a result, the frequency temperature behaviour as shown in FIG. 10 is also obtained. In a more detail, the resonator shape of FIG. 11, is provided by flexural mode, tuning fork, quartz crystal resonators 130 and 131 which are connected and formed integrally at their tuning fork base 132. These are arranged in parallel in the length direction. The tuning fork tines 133, 135 and the tuning fork base of the flexural mode, tuning fork, quartz crystal resonator 130 have grooves 134, 136 and grooves 137, 138, respectively. The grooves 134 and 136 constructed within the tuning fork tines 133 and 135 extend to the tuning fork base of the resonator 130.

Furthermore, the tuning fork tines 139, 141 and the tuning fork base of the flexural mode, tuning fork, quartz crystal resonator 131 have grooves 140, 142 and grooves 143, 144. In this case, the grooves 140 and 142 extend to the tuning fork base of the resonator 131. Thus, as both flexural mode quartz crystal resonators of tuning fork type 130, 131 are connected and formed integrally at each tuning fork base 132, the miniaturization of said resonator is possible, and two flexural mode quartz crystal resonators with different frequency temperature behaviour can be obtained easily. In addition, an integrally formed flexural mode, tuning fork, quartz crystal resonator with excellent frequency temperature behaviour can be realized by electrically connecting these two resonator components in parallel.

### Embodiment 6

FIG. 12 shows another embodiment of the present invention, and a plan view of a flexural mode, tuning fork, quartz crystal resonator embodying the present invention. The flexural mode, tuning fork, quartz crystal resonator 145 comprises tuning fork tines 146, 147 and tuning fork base 148. At least one end of the tuning fork tines 146 and 147 connected to the tuning fork base 148. In this embodiment, a plurality of grooves 149, 150, 151 and 152 are constructed only within the tuning fork base 148. Additionally, a plurality of grooves is similarly constructed within the reverse face of tuning fork base 148.

In addition, the grooves 149 and 150 are constructed within the tuning fork base 148 where at least one end of the tuning fork tines 146 and 147 is connected to the tuning fork base 148. Furthermore, the grooves 151 and 152 are constructed between the grooves 149 and 150. The electrode disposition and the construction is not shown, but is similar to that already explained in detail in FIG. 6. Thus, by constructing the grooves and the electrodes, a flexural mode, tuning fork, quartz crystal resonator is obtained with a small series resistance R₁ and a high quality factor Q because a large distortion occurs at the tuning fork base.

### Embodiment 7

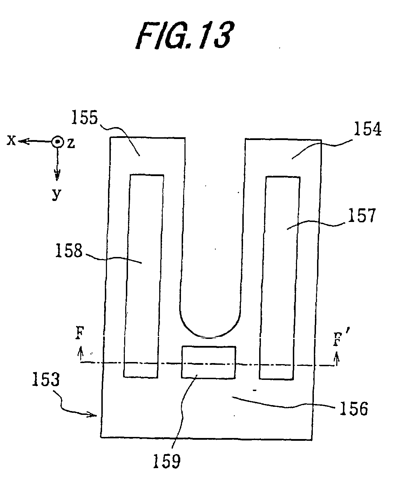

FIG. 13 shows another embodiment of the present invention, and a plan view of a flexural mode, tuning fork, quartz crystal resonator 153embodying the present invention. The quartz crystal resonator of tuning fork type 153 comprises the tuning fork tines 154, 155 and the tuning fork base 156. The tuning fork tines 154 and 155 have grooves 157 and 158 which extend to the tuning fork base 156. In addition, a groove 159 constructed between the grooves 157 and 158 and constructed within the tuning fork base 156.

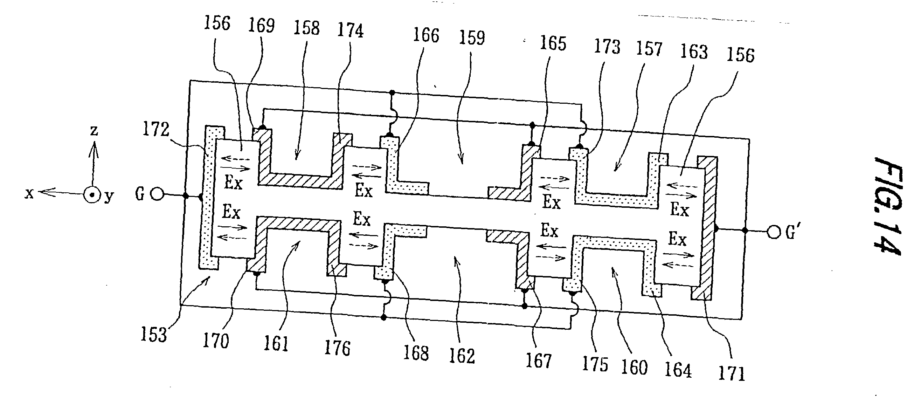

FIG. 14 shows F-F' cross-sectional view of the tuning fork base 156 for the flexural mode quartz crystal resonator 153 of FIG. 13. Here, the shape and the electrode construction of the cross-sectional view of the tuning fork base 156 for the quartz crystal resonator 153 in FIG. 13 are described in detail. As shown in FIG. 14, the quartz crystal resonator 153 has grooves 157 and 160 within the obverse and the reverse faces of the tuning fork base 156 where it connects to the tuning fork tine 154. The groove 157 is constructed opposite the groove 160. Similarly, the resonator 153 has grooves 158 and 161 within the obverse and the reverse faces of the tuning fork base 156 where it connects to the tuning fork tine 155. The groove 158 is constructed opposite groove 161. In addition, the groove 159 is constructed between the groove 157 and the groove 158, and the groove 162 constructed opposite groove 159 is constructed between the groove 160 and groove 161.

Furthermore, the grooves 157, 160 have the electrodes 163, 164 of the same polarity, the grooves 159, 162 have the electrodes 165, 166 and the electrodes 167, 168, the grooves 158, 161 have the electrodes 169, 170 of the same polarity, and both sides of the tuning fork base 156 have the electrodes 171, 172 of opposite polarities. The electrodes are connected in such a way that electrodes disposed opposite the sides of the grooves 157, 158, 159, 160, 161, 162 have different polarities. Thus, the electrodes 165, 167, 169, 170, 171 are all the same polarity while the electrodes 163, 164, 166, 168, 172 are the opposite polarity. As a result, the embodiment of the present resonator has two electrode terminals G-G'.

Therefore, the groove 159 has the electrode 165 and the electrode 166 each of opposite polarity, similarly, the groove 162 has the electrode 167 and the electrode 168 each of opposite polarity. The electrodes disposed opposite the electrodes disposed on the sides of the adjoining grooves in the x-axis direction are of opposite polarity. That is, in this embodiment, the electrode 173 disposed on the side of the grooves 157 opposite to the electrode 165 disposed on the side of the groove 159 are of opposite polarities, similarly, the electrodes 175 and 167 are of opposite polarities, the electrodes 166 and 174 are also of opposite polarities, and the electrodes 168 and 176 are of opposite polarities. In addition, the electrode 163 and the electrode 164 disposed inside the grooves 157 and 160 constructed opposite in the thickness (z-axis) direction are the same polarity. Likewise, the electrode 169 and the electrode 170 disposed inside the grooves 158 and 161 constructed opposite in the thickness (z-axis) direction are also the same polarity. The electrodes 163, 164, 169, 170 disposed inside the grooves 157, 160, 158, 161 and the electrodes 171, 172 disposed on the sides of the tuning fork base 156 extend from the tuning fork base 156 to the tuning fork tines 154, 155.

Now, when an alternating voltage is applied between two electrode terminals G-G', an electric field Eₓ occurs alternately along the arrow directions shown by the solid and broken lines. As a result, a flexural mode is generated in the inverse phase. In addition, as the electric field Eₓ occurs perpendicular to the electrodes between the electrodes disposed on the sides of the grooves, the electric field Eₓ becomes large, and as the tuning fork base 156 also has grooves 159, 162 and electrodes 165, 166, 167, 168, a markedly large distortion occurs at the tuning fork base, so that a flexural mode, tuning fork, quartz crystal resonator is obtained with a small series resistance R₁ and a high quality factor Q when it is miniaturized. In the above-mentioned embodiments the grooves are constructed on the tuning fork tines and/or the tuning fork base, but embodiment of the present invention includes holes instead of the grooves or a combination of the grooves and the holes.

### Embodiment 8

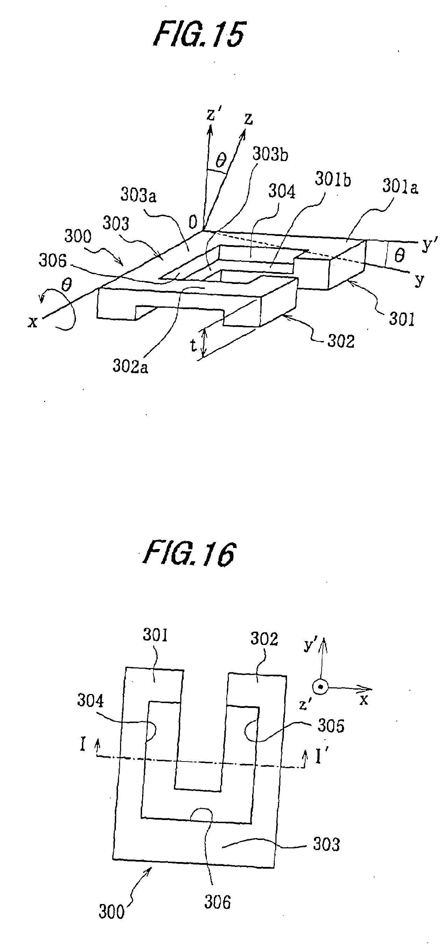

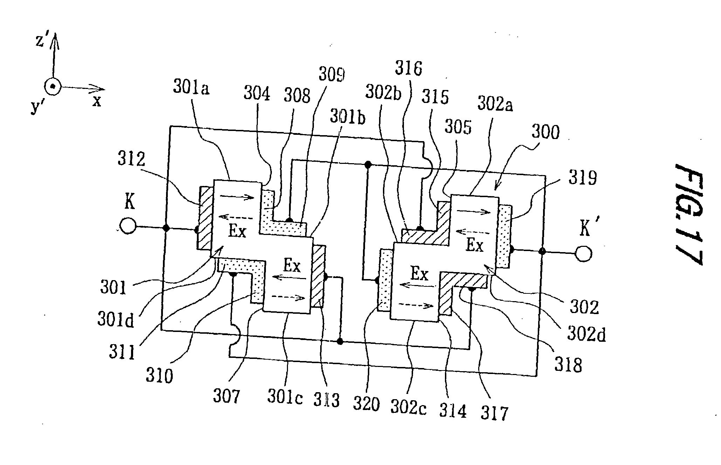

FIG. 15 shows a further embodiment of the present invention, and a general view of a flexural mode, tuning fork, quartz crystal resonator 300 and its coordinate system. FIG. 16 is a plan view of the resonator 300 shown in FIG. 15, and FIG. 17 shows a I-I' cross-sectional view of tuning fork tines shown in FIG. 16. As shown in FIG. 15, the resonator 300 is formed from a quartz crystal wafer rotated about x-axis and with a cut angle θ. In general, a cut angle θ has a value of 0° to 10°. Here, y' and z' axes are the new y and z axes obtained after the rotation about the x-axis. This flexural mode, tuning fork, quartz crystal resonator 300 comprises tuning fork tines 301, 302 and tuning fork base 303, and has thickness t. In addition, the tuning fork tine 301 has step difference portions, and the step difference portion 304 (the inner side of upper surface portion 301a) is formed between upper surface portion 301a and medium surface portion 301b. The medium surface portion 301b and the step difference portion 304 extend to the tuning fork base 303.

Also, similar to the tuning fork tine 301, the medium surface portion 302b and the step difference portion 305 are formed on the obverse face of the tuning fork tine 302, as shown in FIG. 16 and FIG. 17, furthermore, the upper surface portion 303a, the medium surface portion 303b and the step difference portion 306 are formed on the tuning fork base 303. Namely, as shown in FIG. 16, the tuning fork tine 301 of this resonator 300 has the step difference portion 304, while the tuning fork tine 302 has the step difference portion 305, these step difference portions extend to the tuning fork base 303, and the step difference portions 304 and 305 are connected at the step difference portion 306 of the tuning fork base 303. In this embodiment the step difference portions of tuning fork tines are constructed in series, but embodiment of the present invention includes a plurality of step difference portions divided in the length direction of the tuning fork tines.

In addition, as shown in FIG. 17, a structure similar to the obverse face of the tuning fork tine 301, is also constructed on the reverse face. The step difference portion 307 is formed between the lower surface portion 301c and the medium surface portion 301d and the step difference portion 307 extend to the tuning fork base 303. Here, the step difference portion 304 of the obverse face turns toward the inside of the tuning fork tine 301 and the step difference portion 307 of the reverse face turns toward the outside of the tuning fork tine 301. The electrode 308 is disposed on the step difference portion 304 and the electrode 309, which is connected to the electrode 308, is disposed on the medium surface portion 301b.The electrode 310 is disposed on the step difference portion 307 and the electrode 311, which is connected to the electrode 310, is disposed on the medium surface portion 301d. In addition, the electrode 312 is disposed on the side of the tine 301 opposite the electrode 308 disposed on the step difference portion 304 and the electrode 313 is disposed on the side of the tine 301 opposite the electrode 310 disposed on the step difference portion 307.

Thus, by this arrangement of electrodes, an electric field Eₓ occurs perpendicularly between the electrodes 308 and 312 and the electrodes 310 and 313. Similarly, the tuning fork tine 302 also has the step difference and the electrodes of left and right symmetry to the tuning fork tine 301. Namely, the step difference portions 305, 314, the upper surface portion 302a, the medium surface portion 302b and the medium surface portion 302d are constructed on the obverse and the reverse faces of the tuning fork tine 302. The electrode 315 is disposed on the step difference portion 305 and the electrode 316, which is connected to the electrode 315, is disposed on the medium surface portion 302b, and also the electrode 317 is disposed on the step difference portion 314 and electrode 318, which is connected to the electrode 317, is disposed on the medium surface portion 302d. In addition, the electrode 319 is disposed on the side of the tine 302 opposite the electrode 315 and the electrode 320 is disposed on the side of the tine 302 opposite the electrode 317. In more detail, the first set of electrodes 308, 309, 310, 311, 319 and 320 are the same polarity and the second set of electrodes 312, 313, 315, 316, 317 and 318 are the opposite polarity to the first set of electrodes. As a result, two electrode terminals K-K' are constructed.

Now, when an alternating voltage is applied between the electrode terminals K-K', an electric field Eₓ occurs perpendicularly and alternately between the electrodes, as shown by the solid and broken arrow signs in FIG. 17 and a flexural mode vibration can be easily excited, so that a flexural mode, tuning fork, quartz crystal resonator is obtained with a small series resistance R1 and a high quality factor Q because the electro-mechanical transformation efficiency for the resonator becomes large.

### Embodiment 9

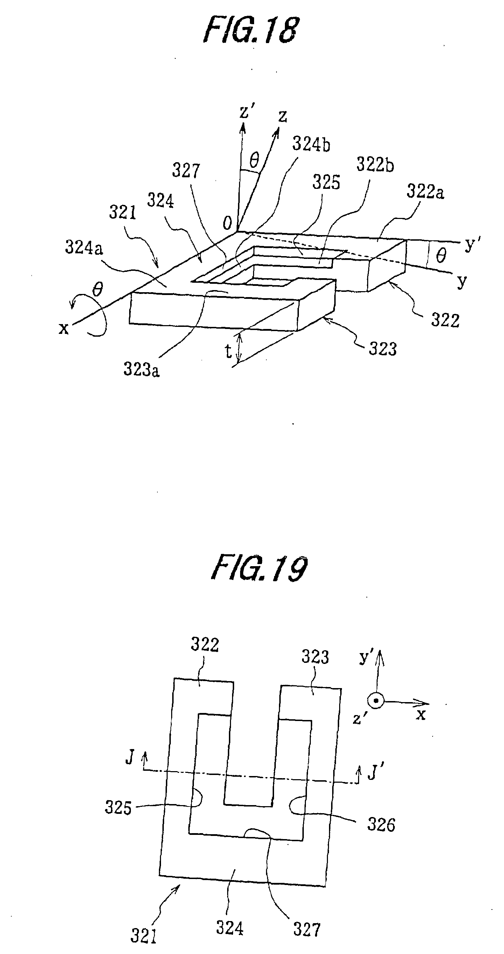

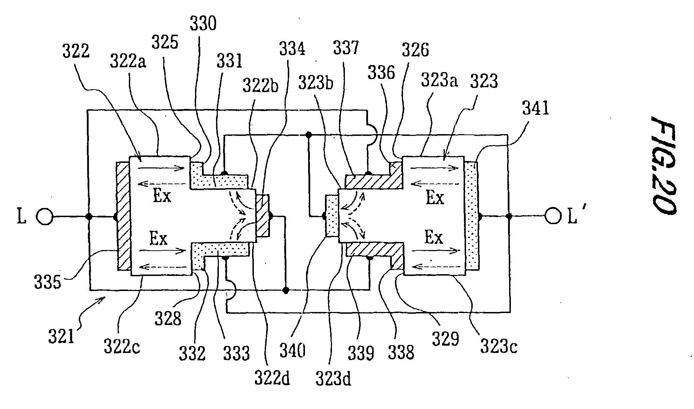

FIG. 18 shows still another embodiment of the present invention, and a general view of a flexural mode, tuning fork, quartz crystal resonator 321 and its coordinate system. FIG. 19 is a plan view of the resonator 321 of FIG. 18, and FIG. 20 shows a J-J' cross- sectional view of tuning fork tines of FIG. 19. Here, the coordinate system in this embodiment is the same as that shown in FIG. 15. A flexural mode, tuning fork, quartz crystal resonator 321 comprises the tuning fork tines 322, 323 and the tuning fork base 324, and has a thickness t. In addition, the tuning fork tine 322 has the step difference, as shown in FIG. 18 and FIG. 20The upper surface portion 322a, the medium portion 322b, 322d, the step difference portion 325, 328 and the lower surface portion 322c are formed on the tuning fork tine 322. The medium surface portion 322b, 322d, and the step difference portion 325, 328 extend to the tuning fork base 324 whose obverse face is shaped to the upper surface portion 324a, the medium surface portion 324b and the step difference portion 327 and whose reverse face has the same shape as the obverse face (though the shape is not shown in the FIGs. 18 and 19).

In the same way, the upper surface 323a, the medium portions 323b, 323d, the step difference portions 326, 329 and the lower surface portion 323c are formed on the tuning fork tine 323. The medium surface portions 323b, 323d and the step difference portions 326, 329 extend to the tuning fork base 324 in a manner similar to said tuning fork tine 322. In other words, as shown in FIGs. 19 and 20, the tuning fork tines 322 and 323 have the step difference portions 325 and 326 which extend to the tuning fork base 324 and connect at the step difference portion 327. In addition, the step difference portions 325 and 328 are constructed at the obverse and the reverse faces of the tuning fork tine 322 and also the step difference portion 326 and 329 are constructed on the obverse and the reverse faces of the tuning fork tine 323. In this embodiment, the step difference portions 325, 328 and 326, 329 turn to the inside of the tuning fork tines 322 and 323, the same effect is obtained when said step difference portions 325, 328 and 326, 329 turn to outside of said tines 322 and 323.

Furthermore, the electrode 330 is disposed on the step difference portion 325 and electrode 331, which is connected to the electrode 330, is disposed on the medium surface portion 322b, electrode 332 is also disposed on the step difference portion 328 and electrode 333, which is connected to the electrode 332, is disposed on the medium surface portion 322d, and electrodes 334, 335 are disposed on both sides of the tuning fork tine 322. Namely, electrode 335 is disposed opposite electrodes 330 and 332 which are of opposite polarity from said electrode 335. Similar to said tuning fork tine 322, the tuning fork tine 323also has the step difference and electrodes of left and right symmetry to said tuning fork tine 322.

That is to say, the tuning fork tine 323 has the difference portions 326, 329, the upper surface portion 323a, the medium surface portions 323b, 323d and the lower surface portion 323c, and the step difference portion 326 has electrode 336, which is connected to electrode 337, disposed on the medium surface portion 323b, while the step difference portion 329 has electrode 338, which is connected to electrode 339, disposed on the medium surface portion 323d, and electrodes 340, 341 are disposed on both sides of the tuning fork tine 323. Namely, electrode 341 is disposed in opposition to electrodes 336 and 338 which are of opposite polarity from said electrode 341. In full detail, as shown in FIG. 20, the first set of electrodes 330, 331, 332, 333, 340 and 341 have the same polarity, while the second set of electrodes 334, 335, 336, 337, 338 and 339 are of opposite polarity to the first set of electrodes. Two electrode terminals L-L' are able to be constructed.

When an alternating voltage is applied between the two electrode terminals L-L', an electric field Eₓ occurs perpendicular to and alternately between the electrodes, as shown by the solid and broken arrow signs in FIG. 20 and a flexural mode vibration may be easily excited, so that a flexural mode, tuning fork, quartz crystal resonator is obtained with a small series resistance R₁ and a high quality factor Q because the electro-mechanical transformation efficiency for the resonator becomes large. In this embodiment, the tuning fork tines 322 and 323 have the medium surface portions 322b, 322d, 323b and 323d on the inside of the said tines, but, the same effect as that of said shape can be obtained when the medium surface portions are constructed on the outside of the tuning fork tines 322 and 323.

### Embodiment 10

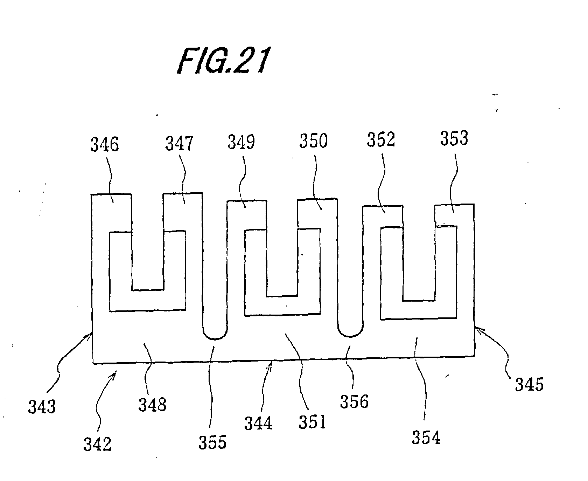

FIG. 21 shows another embodiment of the present invention, and a plan view of a flexural mode, tuning fork, quartz crystal resonator 342. In this embodiment three flexural mode, tuning fork, quartz crystal resonators 343, 344, 345 are connected at the tuning fork bases and are formed integrally by an etching or mechanical process. Also, as shown in FIG. 21, each resonator 343, 344 and 345 uses the step difference embodiment flexural mode, tuning fork, quartz crystal resonator 300 and 321. Here, the first resonator 343 comprises the tuning fork tines 346, 347 and the tuning fork base 348, the second resonator 344 comprises the tuning fork tines 349, 350 and the tuning fork base 351 and the third resonator 345 comprises the tuning fork tines 352, 353 and the tuning fork base 354. The first resonator 343 and the second resonator 344 are formed integrally through the base portion 355 of the tuning fork bases 348 and 351.

Likewise, the second resonator 344 and the third resonator 345 are formed integrally through the base portion 356 of the tuning fork bases 351 and 354. These resonators 343, 344 and 345 are so designed each with a different ratio of width and length of the tuning fork tines. As a result of which, the three pieces of the flexural mode, tuning fork, quartz crystal resonator 343, 344 and 345 are integrally formed with differing frequency temperature behaviour and obtained as a single piece of integrated quartz crystal resonator.

In addition, as described in full detail within the embodiments described by FIGs. 8-11, an improvement of the frequency temperature behaviour in said embodiment may be performed by connecting these resonators 343, 344 and 345 in parallel electrically. In this embodiment, it is taught by using three pieces of resonator, but, the connection of quartz crystal resonators for more than three pieces also gives the same effect.

Furthermore, in said embodiments, integrated plurality component flexural mode, tuning fork, quartz crystal resonators with the same shape are used to improve the frequency temperature behaviour, however, the frequency temperature behaviour can be improved by the other methods, namely, by connection methods, for example, (1) by a combination of a flexural mode quartz crystal resonator of tuning fork type with grooves as shown in FIGs. 1, 5, 12 and 13 and a flexural mode, tuning fork, quartz crystal resonator with step difference as shown in FIGs. 15 and 18, (2) by a combination of the resonators as shown in FIGs. 1, 5, 12 and 13. (3) by a combination of the resonators as shown in FIGs. 15 and 18, (4) by a combination of the resonators as shown in FIGs. 1, 5, 12, 13, 15 and 18 and the conventional resonator as shown in FIGs. 22 and 23.

In other words, an improvement of the frequency temperature behaviour can be accomplished by employing a flexural mode, tuning fork, quartz crystal resonator embodying the present invention and connecting it to another resonator in parallel electrically. In addition, embodiments of the present invention include two methods of electrode disposition which determine a vibration mode of tuning fork tines: (1) Electrodes are disposed so that each flexural mode, tuning fork, quartz crystal resonator consisting of a plurality of resonators connected and formed integrally at the tuning fork bases vibrate in the same vibration mode, or, (2) Electrodes are so disposed that a flexural mode, tuning fork, quartz crystal resonator consisting of a plurality of component resonators connected and formed integrally at the tuning fork bases vibrate in different modes.

Also, each flexural mode quartz crystal resonator is connected and formed integrally side by side in the present embodiments as shown in FIGs. 8, 11 and 21. However, the present invention is not limited to flexural mode, tuning fork, quartz crystal resonator connected and formed integrally side by side, but includes the connection and integrated formation of any shapes at the tuning fork bases.

In addition, in the present embodiments a flexural mode quartz crystal resonator of tuning fork type has two tuning fork tines, but embodiments of the present invention include a plurality of tuning fork tines Embodiments of the present invention also include flexural mode, tuning fork, quartz crystal resonators which are connected and formed integrally at the tuning fork bases consisting of more than three component pieces of tuning fork, quartz crystal resonator. Also, embodiments of the present invention include the teaching that each resonator consisting of a plurality of flexural mode, tuning fork, quartz crystal resonators which are connected and formed integrally at each tuning fork base, which may have different resonator shapes and different electrode depositions.

Furthermore, two flexural mode, tuning fork, quartz crystal resonators are connected and formed integrally with an angle of φ at each tuning fork base as shown in the embodiment of FIG. 8, and also embodiments of the present invention include the following flexural mode, tuning fork, quartz crystal resonator which has the same effect as said resonators with an angle of φ, namely, the tuning fork bases of the plurality of the flexural mode, tuning fork, quartz crystal resonators are formed in parallel and one of the plurality of component resonators is at least designed and formed so that two tuning fork tines turn to the inside with an angle of φ or turn to the outside with an angle of φ. It is needless to say that these resonators are connected and formed integrally at the tuning fork bases.

As mentioned above, by providing flexural mode, tuning fork, quartz crystal resonators with the resonator shape and the electrode construction in embodiments of the present invention, the outstanding effects may be obtained as follow:
(1) As the grooves are constructed including a portion of the central line of the tuning fork tines, an electric field occurs perpendicular to the electrodes, so that a flexural mode quartz crystal resonator with a small series resistance R₁ and a high quality factor Q is obtained because the electro-mechanical transformation efficiency becomes large.
(2) A flexural mode, tuning fork, quartz crystal resonator is obtained with a small series resistance R₁, even if it is miniaturized.
(3) As two flexural mode, tuning fork, quartz crystal resonators are formed integrally by an etching process and are connected in parallel electrically, an integrally formed and miniaturized quartz crystal resonator can be realized with excellent frequency temperature behaviour.
(4) A low price quartz crystal resonator can be realized because it is formed integrally by an etching process which makes it possible to form many resonators on a piece of quartz wafer.
(5) As the prior art quartz crystal resonators are based on the tuning fork type, it is easy to mount the flexural mode, tuning fork, quartz crystal resonators on two lead wires or a pedestal. As a result, energy losses at mounting caused by the vibration of tuning fork tines decrease and the resonators obtained are shock resistant.
(6) As there is a plurality of grooves on the tuning fork base and electrodes of opposite polarities are disposed opposite the sides of adjoining grooves, the distortion at the tuning fork base is markedly large, so that a miniaturized flexural mode quartz crystal resonator of tuning fork type is obtained with a small series resistance R₁ and a high quality factor Q.
(7) As grooves are constructed including the central line of tuning fork tine, electrodes are disposed on said grooves and said grooves extend to tuning fork base, the quantity of distortion at the tuning fork base becomes remarkably large. Therefore, a miniaturized flexural mode, tuning fork, quartz crystal resonator is obtained with a small series resistance R₁ and a high quality factor Q because the electro-mechanical transformation efficiency gets large.
(8) As electrodes are disposed on step difference portions constructed at the obverse and the reverse faces of the width direction and the sides of tuning fork tine opposite said electrodes have electrodes of opposite polarity to said electrodes, the electro-mechanical transformation efficiency becomes very large. As a result, a flexural mode, tuning fork, quartz crystal resonator can be realized with a small series resistance R₁ and a high quality factor Q.
(9) A markedly narrow width tuning fork tines can be obtained maintaining sufficiently large electro-mechanical transformation efficiency because the step difference is constructed on the tuning fork tines.
(10)As a plurality of flexural mode, tuning fork, quartz crystal resonators are formed integrally and connected in parallel electrically, the compound series resistance R₁ for the compound resonator becomes small. For example, when two pieces of resonator with the same series resistance R₁ are used, a compound resonator formed from embodiments of the present invention have half the series resistance R₁. Therefore, a compound series resistance R₁ can be decreased still more by increasing the number of resonators which are formed integrally. (11)As plural flexural mode, tuning fork, quartz crystal resonators are formed integrally, and connected in parallel electrically the function can be maintained as a resonator, even if one of the plural resonators is broken by some cause, for example by shock.

As described above, it will be easily understood that the flexural mode, tuning fork, quartz crystal resonators with novel shapes and the novel electrode construction according to the present invention may have the same outstanding effects. In addition to this, while the present invention has been shown and described with reference to preferred embodiments thereof, it will be understood by those skilled in the art that the changes in shape and electrode construction can be made therein without departing from the spirit and scope of the present invention.

## Claims

1. A tuning fork, quartz crystal resonator vibrating in flexural mode comprising;
tuning fork tines, and
a tuning fork base,
at least one groove provided in the central line portion of each of said tuning fork tines,
at least one first electrode provided inside each groove,
at least one second electrode provided on the sides of said tuning fork tines , and
for each tine said at least one second electrode having an opposite polarity to said at least one first electrode.

2. A resonator as defined in claim 1 wherein
the at least one first electrode inside the at least one groove of the first tuning fork tine and the at least one second electrode disposed on the sides of the second tuning fork tine are the same first polarity, and the at least one second electrode disposed on the sides of the first tuning fork tine and the at least one first electrode inside the at least one groove of the second tuning fork tine are the opposite to the said first polarity.

3. A resonator as defined in claim 2 wherein said resonator comprises two electrode terminals.

4. A resonator as defined in claim 1 or claim 2 wherein the grooves constructed at the central portion including the central line of the tuning fork tines extend to the tuning fork base coupled to each tuning fork tine.

5. A resonator as defined in claim 1 or claim 2 wherein groove width W₂ constructed on the tuning fork tines are greater to or equal to the width from the edge of the groove to the edge of the tine W₁, W₃.

6. A quartz crystal, tuning fork, resonator vibrating in flexural mode comprising;
tuning fork tines,
tuning fork base,
a plurality of grooves provided on the tuning fork base where said base is coupled to the tuning fork tines, and
electrodes provided in said grooves.

7. A resonator as defined in claim 6 wherein
a first set of grooves are constructed on the obverse and the reverse faces of the tuning fork base where said base connects to each tuning fork tine, and
a second set of grooves are constructed on the obverse and the reverse faces between said first set of grooves.

8. A resonator as defined in claim 6 or claim 7 wherein
the electrodes disposed opposite each other in the thickness direction of the grooves have the same polarity, and
the electrodes disposed opposite the sides of adjoining grooves have opposite polarities.

9. A resonator as defined in any proceeding claim wherein the tuning fork base has a plurality of grooves, and said grooves containing the electrodes.

10. A tuning fork, quartz crystal resonator vibrating in flexural mode comprising;
tuning fork tines,
a tuning fork base,
said tuning fork tines having step difference portions,
with at least one first electrode on the said step difference portions, with at least one second electrode disposed on the side of said tuning fork tines, and
said at least one first and at least one second electrodes being of opposite polarity.

11. A resonator comprising a plurality of resonators as claimed in any preceding claim.

12. A resonator comprising as defined in claim 11 wherein said plurality of flexural mode, tuning fork, quartz crystal resonators are connected at each tuning fork base.

13. A resonator comprising;
a plurality of flexural mode, tuning fork, quartz crystal resonators being connected and formed integrally at each tuning fork base wherein said quartz crystal resonators are coupled to each other at the respective tuning fork bases and having an angle of separation of 0° to 30°.

14. A resonator as defined in claims 11-13 wherein each of the plurality of tuning fork resonators have a different resonator shape and/or a different electrode deposition.

15. A resonator as defined in any of the claims 11, 12 or 13 wherein said resonators are arranged side by side.

16. A resonator as defined in any of the claims 11-15 wherein said resonators are electrically connected in parallel.

17. A resonator as defined in any of the claims 1-7, wherein the grooves constructed on the tuning fork tines and/or the tuning fork base are holes or a combination of the grooves and the holes, and said holes or said grooves and holes containing the electrodes.
